# EUROPEAN PATENT APPLICATION

(11) **EP 4 794 488 A1**
(43) Date of publication of application: **19.08.2026**
(21) Application number: 24876823.6
(22) Date of filing: 12.11.2024
(51) Int. Cl.: H10F 71/00, H10F 19/90

(54) **SOLAR CELL MANUFACTURING APPARATUS AND SOLAR CELL MANUFACTURING METHOD**

(30) Priority: 11.10.2023 KR 20230134844
(71) Applicant: Hanwha Solutions Corporation, Seoul 04541 (KR)
(72) Inventor: JUNG, Min Kyo, Seoul 04541 (KR); BAEK, Dong Heon, Seoul 04541 (KR); JEON, Sung Gyu, Seoul 04541 (KR); CHUNG, Dong Jin, Seoul 04541 (KR)
(74) Representative: Mooser, Sebastian Thomas
(86) International application number: PCT/IB2024/061212
(87) International publication number: WO 2025/079057

(57) **Abstract**

A solar cell manufacturing apparatus includes: a plurality of stages arranged in a row to contact each other, each having a solar cell seated thereon; a base conveying the plurality of stages to a curing zone while supporting the plurality of stages; and a pin feeder disposed at one side of the base and feeding a pin between two predetermined adjacent stages among the plurality of stages, wherein the two stages coupled to the pin fed through the pin feeder are spaced apart from each other.

## Description

### [Technical Field]

Embodiments of the present invention relate to a solar cell manufacturing apparatus and a solar cell manufacturing method.

### [Background Art]

A solar cell is formed by disposing a diode having a p-n junction on a substrate. When sunlight reaches a solar cell, the solar cell creates an exciton, that is, an electron-hole pair, and the exciton splits into electrons and holes, which migrate to an n-layer and to a p-layer, respectively, thereby generating photovoltaic electricity across the p-n junction. Tabbing refers to a process of forming a single solar cell module through electrical connection of multiple solar cells to one another by placing wires on the solar cells.

Here, a process of bonding the solar cells and the wires includes applying an electrically conductive adhesive (ECA) to the surfaces of the solar cells and bonding the wires to the solar cells.

The process of bonding the solar cells to the wires using the electrically conductive adhesive is a next generation process for manufacturing solar cells and various studies have been conducted on specific embodiments thereof.

### [Disclosure]

### [Technical Problem]

It is an object of the present invention to provide a solar cell manufacturing apparatus and a solar cell manufacturing method including a process of bonding a solar cell and a wire using an adhesive.

The above object is provided by way of example and the present invention is not limited thereto.

### [Technical Solution]

1. One aspect of the present invention relates to a solar cell manufacturing apparatus. The solar cell manufacturing apparatus includes: a plurality of stages arranged in a row to contact each other, each having a solar cell seated thereon; a base conveying the plurality of stages to a curing zone while supporting the plurality of stages; and a pin feeder disposed at one side of the base and feeding a pin between two predetermined adjacent stages among the plurality of stages, wherein the two stages coupled to the pin fed through the pin feeder are spaced apart from each other.
2. In embodiment 1, the pin feeder may include: a pin feeder body; and a pin insertion unit disposed in the pin feeder body and inserting at least one pin into one side of the stage.
3. In embodiment 2, the plurality of stages may form a plurality of stage modules arranged in a row while contacting each other, the plurality of stage modules may be sequentially conveyed on the base, and the pin may be inserted between two adjacent stage modules.
4. In embodiment 3, the pin insertion unit may include: a first pin insertion unit disposed at one side of the pin feeder body and inserting a first pin into one side of the stage; and a second pin insertion unit disposed at the other side of the pin feeder body and inserting a second pin into the other side of the stage, the first and second pin insertion units alternately inserting the first pin and the second pin between the plurality of the stage modules being conveyed.
5. In embodiment 2, the solar cell manufacturing apparatus may further include a stage feeder receiving a stage into which the pin is to be inserted, the stage feeder placing the stage at a location thereon corresponding to the pin feeder.
6. In embodiment 5, the stage feeder may include a gripper contact portion contacting the pin feeder when the pin is inserted into the stage.
7. In embodiment 1, the pin may have a length (L2) ranging from about 10% to about 20% of a length (L1) of the stage.
8. In embodiment 1, each of the stages may be formed on a side surface thereof with a pin insertion hole and the pin may be inserted into the pin insertion hole.
9. Another aspect of the present invention relates to a solar cell manufacturing method. The solar cell manufacturing method includes the steps of: feeding a stage; feeding a wire onto the stage; feeding a solar cell and a jig onto the stage fed the wire; pre-heating the solar cell and the jig on the stage; curing the solar cell and the jig on the stage; and discharging the solar cell, wherein the step of feeding a stage includes the steps of: inserting a first pin into the stage; and inserting a second pin into the stage.
10. In embodiment 9, the step of inserting a first pin into the stage and the step of inserting a second pin into the stage may be alternately performed.
11. In embodiment 9, the step of inserting a first pin into the stage may include: gripping the first pin; inserting the first pin into a first pin insertion hole of the stage; releasing gripping of the first pin; and shifting a pin feeder in a direction different from a location at which the stage is disposed.

The above and other aspects, features, and advantages of the present invention will become apparent from the detailed description, claims, and drawings for practicing the invention.

### [Advantageous Effects]

In a solar cell manufacturing apparatus and a solar cell manufacturing method according to embodiments of the present invention, pins are supplied between one stage module forming one solar cell module and including a plurality of stages and the other second stage module forming another solar cell module and including a plurality of stages to cut a wire connecting the first stage module and the second stage module. As a result, a constant distance between the stage modules can be automatically maintained during conveyance for curing the plurality of stages on a base, whereby a wire between the one stage module and the other stage module can be effectively cut.

Furthermore, the solar cell manufacturing apparatus and the solar cell manufacturing method according to the embodiments of the present invention allow replacement of the pins supplied between the one stage module and the other stage module, whereby a space between the one stage module and the other stage module can be flexibly secured.

The effects of the present invention are not limited to the aforementioned effects and other effects not mentioned will become apparent to those skilled in the art from the claims.

### [Description of Drawings]

FIG. 1 is an overall conceptual view of a solar cell manufacturing apparatus according to one embodiment of the present invention.
FIG. 2 is a diagram sequentially illustrating a process of connecting solar cells and wires according to one embodiment of the present invention.
FIG. 3 is a perspective view of a solar cell manufacturing apparatus according to one embodiment of the present invention.
FIG. 4 is a perspective view of the solar cell manufacturing apparatus including the curing unit according to one embodiment of the present invention, illustrating a stage placed therein
FIG. 5 is a bottom view of Part A1 of FIG. 4, that is, the curing unit.
FIG. 6 is a top view of Part A2 of FIG. 4, that is, a base.
FIG. 7 is an enlarged view of Part B of FIG. 4.
FIG. 8 is a side view illustrating two stages of Part A of FIG. 3 and pins between the two stages.
FIG. 9 is a conceptual diagram illustrating a cutting process in a gap G created by the pins according to one embodiment of the present invention.
FIG. 10 is an enlarged perspective view illustrating a pin feeder according to one embodiment of the present invention, stages to which the pin feeder feeds the pins, and peripheral configurations.
FIG. 11 is a side view of Part B of FIG. 4.
FIG. 12 is a plan view of Part C of FIG. 10, illustrating a first pin gripper of a first pin insertion unit, which grips a first pin.
FIG. 13 is a plan view of Part C of FIG. 10, illustrating a first pin insertion unit shifter of the first pin insertion unit, which shifts the first pin gripper in a direction in which a stage is disposed, and the first pin gripper inserting the first pin into a first pin insertion hole of the stage.
FIG. 14 is a plan view of Part C of FIG. 10, illustrating the first pin gripper releasing a pin.
FIG. 15 is a plan view of Part C FIG. 10, illustrating the first pin insertion unit shifter shifting the first pin gripper in a direction opposite to the stage.
FIG. 16 is a flowchart illustrating a method of manufacturing a solar cell according to one embodiment of the present invention.
FIG. 17 is a flowchart illustrating detailed steps in operation of a pin feeder according to one embodiment of the present invention.
FIG. 18 is a flowchart illustrating detailed steps in which a first pin insertion unit disposed at one side of a pin feeder body of FIG. 17 inserts a first pin into a first pin insertion hole of one stage.
FIG. 19 is a flowchart illustrating detailed steps in which a second pin insertion unit disposed at one side of the pin feeder body of FIG. 17 inserts a second pin into a second pin insertion hole of one stage.

### [Best Mode]

The present invention can be modified in various ways and can have various embodiments, some of which are illustrated in the drawings and described in detail in the following description of the invention. However, it should be understood that it is not intended to limit the present invention to any particular embodiments and the present invention includes all modifications, equivalents, or substitutions that fall within the scope of the invention. In description of the invention, the same components will be denoted by the same reference numerals throughout the specification.

Hereinafter, exemplary embodiments of the present invention will be described in detail with reference to the accompanying drawings, in which the same or corresponding components will be denoted by the same reference numerals and repeated description thereof will be omitted.

In the following embodiments, the terms "first", "second", and the like are not intended to be limiting, but are used to distinguish one element from another element.

In the following embodiments, the singular forms "a", "an" and "the" are intended to include the plural forms as well, unless the context clearly indicates otherwise.

In the following embodiments, the terms "includes," "including," "comprises," and/or "comprising," when used in this specification, specify the presence of stated features or components but do not preclude the presence or addition of one or more other features or components.

In the drawings, dimensions of various elements, layers, etc. may be exaggerated or reduced for clarity of illustration. For example, the size and thickness of each element shown in the drawings is arbitrarily shown for ease of description and the present invention is not limited thereto.

When an exemplary embodiment is implemented differently, a specific process order may be performed differently from the described order. For example, two consecutively described processes may be performed substantially at the same time or performed in an order opposite the described order.

The terminology used herein is for the purpose of describing particular embodiments and is not intended to be limiting. Moreover, the terms "includes," "including," "comprises," and/or "comprising," when used in this specification, specify the presence of stated features, integers, steps, operations, elements, components and/or groups thereof but do not preclude the presence or addition of one or more other features, integers, steps, operations, elements, components, and/or groups thereof.

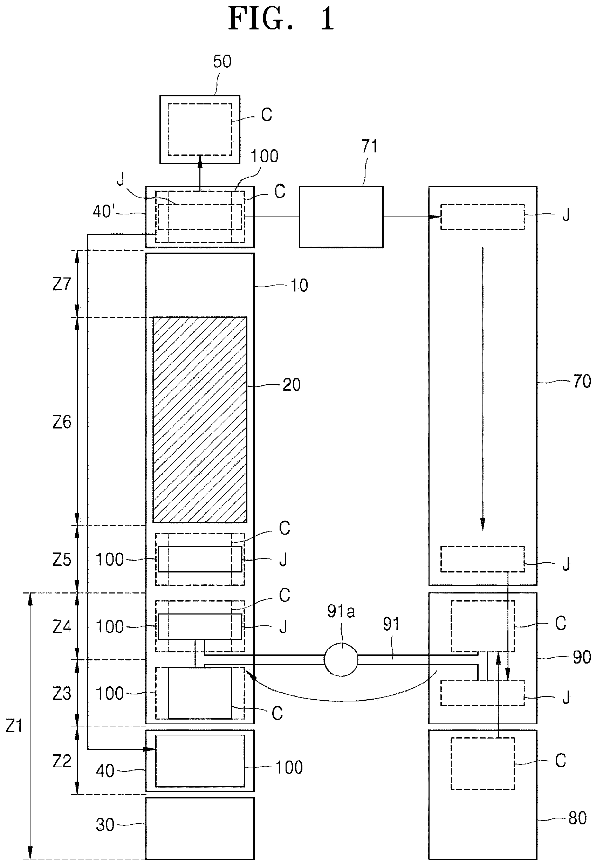

Hereinafter, a solar cell manufacturing apparatus according to one embodiment of the present invention will be described with reference to FIG. 1 to FIG. 9.

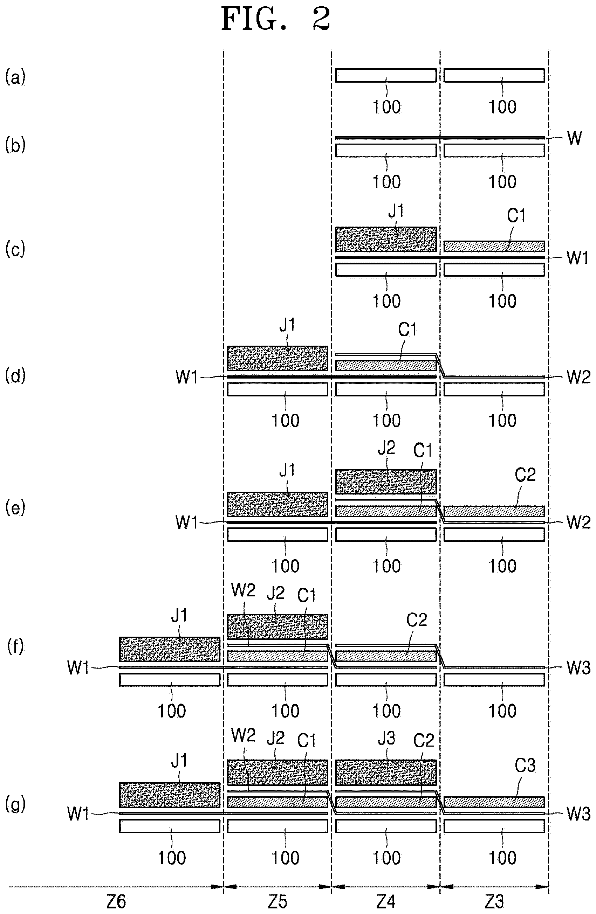

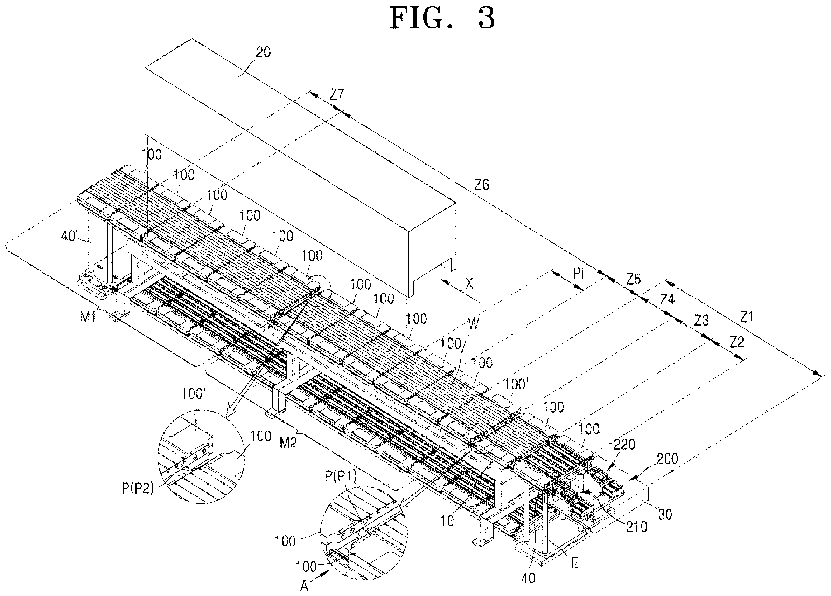

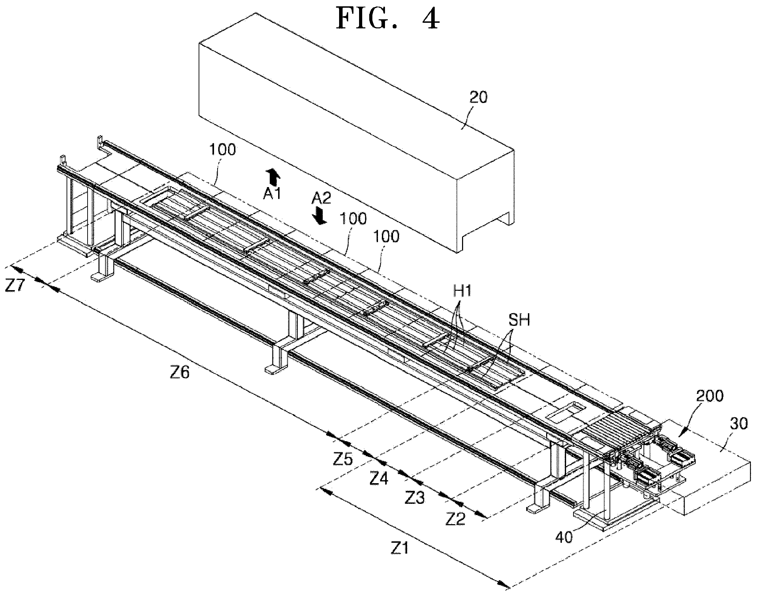

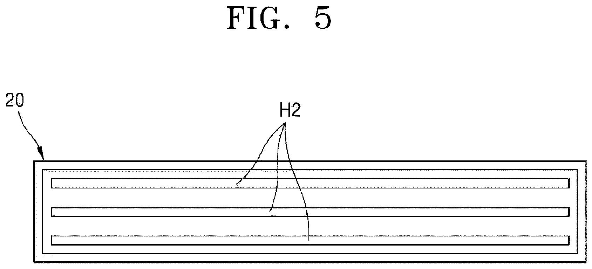

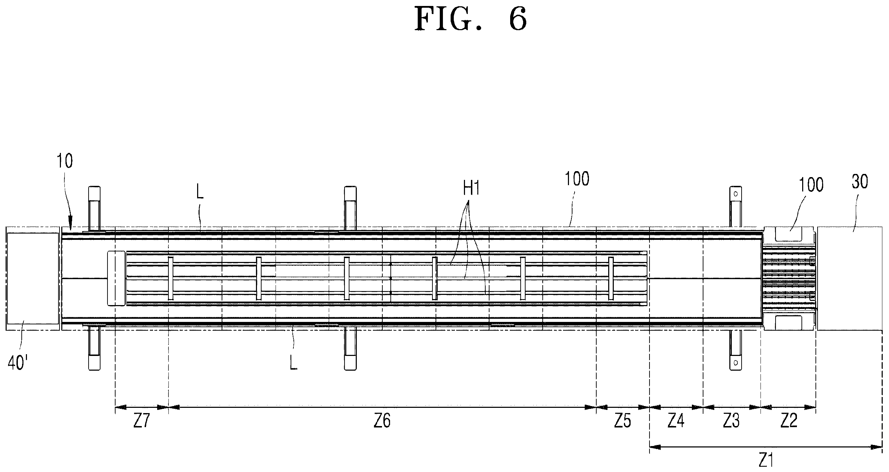

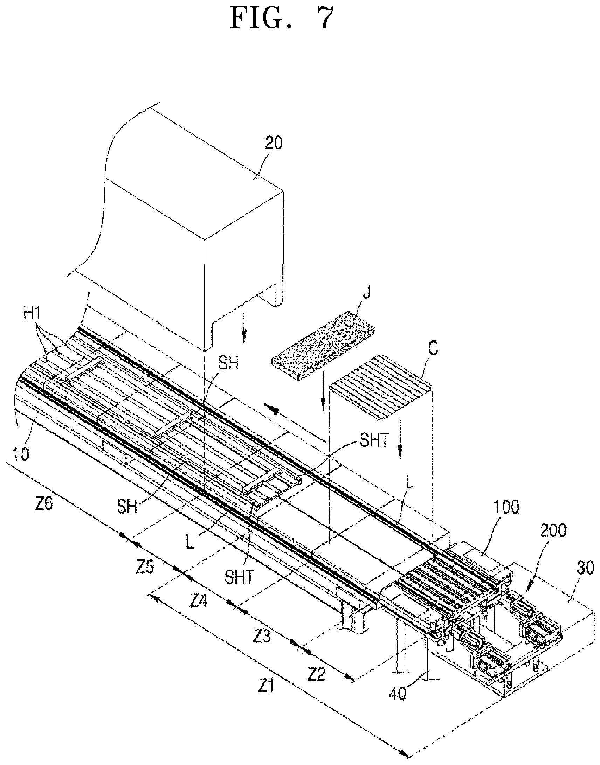

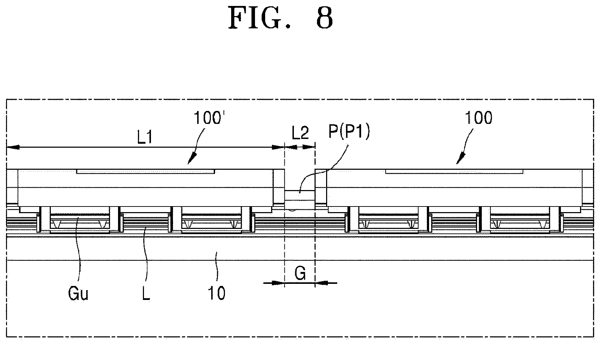

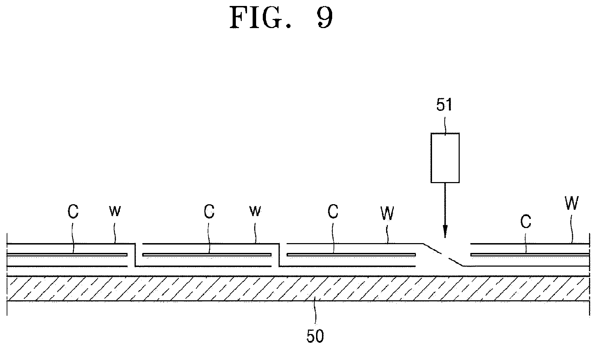

FIG. 1 is an overall conceptual view of a solar cell manufacturing apparatus according to one embodiment of the present invention. FIG. 2 is a diagram sequentially illustrating a process of connecting solar cells and wires according to one embodiment of the present invention. FIG. 3 is a perspective view of a solar cell manufacturing apparatus according to one embodiment of the present invention. FIG. 4 is a perspective view of the solar cell manufacturing apparatus including the curing unit according to one embodiment of the present invention, illustrating a stage placed therein FIG. 5 is a bottom view of Part A1 of FIG. 4, that is, a curing unit. FIG. 6 is a top view of Part A2 of FIG. 4, that is, a base. FIG. 7 is an enlarged view of Part B of FIG. 4. FIG. 8 is a side view illustrating two stages of Part A of FIG. 3 and pins disposed between the two stages. FIG. 9 is a conceptual diagram illustrating a cutting process in a gap G created by the pins according to one embodiment of the present invention.

A solar cell manufacturing apparatus is a device for connecting solar cells C and a wire w to form a solar cell module. The solar cell C includes a semiconductor junction region having a p-n junction surface, and when irradiated with a certain magnitude or more of energy, the solar cell C generates electromotive force to convert light energy into electrical energy. A semiconductor material included in the solar cell C is not limited to a particular material and may include silicon (monocrystalline, polycrystalline, and amorphous silicon), gallium arsenide, cadmium telluride, cadmium sulfide, indium phosphorus, copper indium gallium selenide (CIGS), organic dyes, or mixtures thereof.

The wire w is a conductor for electrically connecting a plurality of solar cells C to each other and is configured to connect front and back surfaces of adjacent solar cells C to each other. For example, the wire w may be electrically connected to the solar cells C through a curing process. Alternatively, the wires w may be electrically connected to the solar cells C through an electrically conductive adhesive (ECA).

Referring to FIG. 1 to FIG. 9, a solar cell manufacturing apparatus according to one embodiment of the present invention includes a plurality of stages 100 arranged in a row to contact each other and each having a solar cell seated thereon; a base 10 conveying the plurality of stages 100 to a curing zone while supporting the plurality of stages 100; and a pin feeder 200 disposed at one side of the base 10 and feeding a pin P between two predetermined adjacent stages among the plurality of stages 100, wherein the two stages 100, 100' coupled to the pin P fed through the pin feeder 200 are spaced apart from each other by the pin P.

Referring to FIG. 1, a curing process may be performed while the solar cells C pass through the curing unit 20 with each of the solar cells C seated on the stage 100. The solar cells C may be fed through a cell feeder 80. The cell feeder 80 may feed the solar cells C with an electrically conductive adhesive (ECA) applied thereto.

The cell feeder 80 may convey the solar cells C with the electrically conductive adhesive applied thereto to a cell-jig feeder 90. In addition, a jig feeder 70 may be disposed at a side opposite the cell feeder 80 with reference to the cell-jig feeder 90 to feed jigs J to the cell-jig feeder 90.

The cell-jig feeder 90 may convey the solar cell C and the jig J to the upper side of the base 10 through a cell-jig conveying unit 91. The cell-jig conveying unit 91 may grip the solar cell C and the jig J together and may rotationally shift the solar cell C and the jig J around a rotational shaft 91a to place the solar cell C and the jig J on the upper side of the base 10. Then, the solar cell C and the jig J disposed on the upper side of the base 10 may be sequentially seated on the stage 100, which in turn may enter a curing zone Z6 together with the solar cell C and the jig J seated thereon to be subjected to the curing process.

A stage feeding zone Z2 may be provided with a stage feeder 40. The stage feeder 40 may feed the stage 100 to the stage feeding zone Z2. The solar cell C and the jig J may be seated on the stage 100 fed to the stage feeding zone Z2 and the stage 100 may pass through the curing zone Z6 together with the solar cell C and the jig J seated thereon to allow the curing process for the solar cell C to be performed.

On the stage 100 having passed through the curing zone Z6 and an outlet zone Z7 described below, the jig J may be separated and retrieved from the stage 100 and the solar cell C by a jig retrieval unit 71. The solar cell C seated on the stage 100 from which the jig J is separated may be separated and discharged from the stage 100 through a cell conveying unit 50. The jig retrieval unit 71 may feed the retrieved jig to the jig feeder 70, which in turn may refeed the retrieved jig to the cell-jig feeder 90.

The cell conveying unit 50 may include a cutting unit 51. After the curing process is completed, the solar cells C separated from the stages and the jigs are conveyed to the cell conveying unit 50, which can discharge the solar cells to the outside as solar cell module units after cutting between one solar cell module and the other solar cell module through the cutting unit 51 disposed in the cell conveying unit 50.

The stage 100 from which the jig J and the solar cell C are separated may be retrieved by a stage retrieval unit 40'. The stage retrieval unit 40' is connected to the stage feeder 40 and the stage 100 retrieved through the stage retrieval unit 40' may be conveyed to the stage feeder 40. The stage feeder 40 may refeed the conveyed stage 100 to the stage feeding zone Z2.

The stage 100 may be conveyed on the base 10 from the stage feeding zone Z2 to the outlet zone Z7. The stage 100 may be conveyed from the stage feeding zone Z2 to a solar cell seating zone Z3. In the solar cell seating zone Z3, the solar cell C fed from the cell-jig feeder 90 may be seated on the stage 100 by the cell-jig conveying unit 91.

With the solar cell C seated on the stage 100, the stage 100 may be conveyed from the solar cell seating zone Z3 to a jig securing zone Z4. In the jig securing zone Z4, the solar cell C may be secured to the stage 100 as soon as the jig J is seated on the stage 100.

With the solar cell C and the jig J seated on the stage 100, the stage 100 may be conveyed from the jig securing zone Z4 to a pre-heating zone Z5. In the pre-heating zone Z5, the solar cell C seated on the stage 100 may be pre-heated through the first heater H1 disposed in the pre-heating zone Z5, prior to the curing process.

With the solar cell C and the jig J seated on the stage 100, the stage 100 may be conveyed from the pre-heating zone Z5 to the curing zone Z6. After entering the curing zone Z6, the solar cell C seated on the stage 100 may be subjected to the curing process.

After passing through the curing zone Z6, the stage 100 with the solar cell C and the jig J seated thereon may be conveyed to the outlet zone Z7. In the outlet zone Z7, the first heater H1 may be disposed to act as a temperature buffering feature to prevent the solar cell C from undergoing a sudden temperature change by slowly reducing a temperature of the solar cell C seated on the stage 100 when the stage 100 is discharged from a high temperature environment in the curing zone Z6.

The stage 100 may be conveyed to the stage retrieval unit 40' through the outlet zone Z7. Here, the jig J may be separated and retrieved from the stage 100 and the solar cell C through the jig retrieval unit 71. The jig retrieval unit 71 may be disposed in a region corresponding to the stage retrieval unit 40'. Accordingly, the jig retrieval unit 71 may retrieve the jig J disposed on the stage retrieval unit 40'. Alternatively, the jig retrieval unit 71 may be placed between the outlet zone Z7 and the stage retrieval unit 40'. Accordingly, the jig retrieval unit 71 may retrieve the jig J disposed in a region corresponding to a jig retrieval region.

In addition, the solar cell C seated on the stage 100 from which the jig J is retrieved may be separated and discharged from the stage 100 through the cell conveying unit 50. Then, the stage 100 may be delivered to the stage feeder 40 through the stage retrieval unit 40' and may be refed to the stage feeding zone Z2.

A wire feeder 30 may be disposed at one side of the stage feeding zone Z2. The wire feeder 30 may extend and convey wires w to the stage feeding zone Z2, the solar cell seating zone Z3, and the jig securing zone Z4 through a gripper to secure the wire w. Here, the extending wire w may be guided by a wire groove formed on the stage 100. Thus, the wire feeding zone Z1 may be a region including the wire feeder 30, the stage feeding zone Z2, the solar cell seating zone Z3, and the jig securing zone Z4.

The wires w may be disposed on upper and lower surfaces of the solar cell C. The wire w disposed on the lower surface of the solar cell C may be guided by the wire groove formed on the stage 100. The wire w disposed on the upper surface of the solar cell C may be secured thereto by the jig J by pressing the wire w onto the upper surface of the solar cell C. The jig J may secure the wire w such that the wire w does not lift or deviate from a specific location when connecting the wire w to the upper surface of the solar cell C.

The wire feeder 30 may include a cutter configured to cut a rolled wire to a preset first length and a gripper configured to extend and convey the wire of the first length to the jig securing zone Z4 through the stage feeding zone Z2 and the solar cell seating zone Z3.

Referring to FIG. 2, in order to perform the curing process, the stages 100 are fed to the stage feeding zone Z2 and the solar cell seating zone Z3 ((a) of FIG. 2) and, when a first wire w1 is fed by the wire feeder 30 ((b) of FIG. 2), the cell-jig conveying unit 91 simultaneously seats a pair of a first solar cell C1 and a first jig J1 on the first wire w1 ((C) of FIG. 2). Here, the cell-jig conveying unit 91 seats the first solar cell C in the solar cell seating zone Z3 and seats the first jig J in the jig securing zone Z4.

Then, the stages 100, the first wire w1, the first jig J1, and the first solar cell C1 are conveyed on the base 10 to the curing zone Z6 by one pitch P and a second wire w is fed onto the conveyed solar cell C ((d) in FIG. 2).

Referring to FIG. 3, the pitch P may be a width P of the stage. Here, the pre-heating zone Z5 may have a width corresponding to the width P of the stage. Specifically, each of the width of the pre-heating zone Z5 and the width P of the stage may refer to a width in a direction parallel to a conveying direction of the solar cell C.

Then, the cell-jig conveying unit 91 simultaneously seats a pair of a second jig J2 and a second solar cell C2 on the second wire w2 ((e) of FIG. 2).

Referring again to FIG. 1, the jig and the solar cell on the stage 100 placed at the stage retrieval unit 40' are picked up to be separated from the stage 100 by the jig retrieval unit 71 and the cell conveying unit 50, respectively.

Then, the first wire w1, the first jig J1, the first solar cell C1, the second wire w2, the second jig J2, and the second solar cell C2 are conveyed on the base 10 to the curing zone Z6 by one pitch P and a third wire w3 is fed onto the conveyed solar cell C ((f) of FIG. 2).

Then, the cell-jig conveying unit 91 simultaneously seats a pair of a third jig J3 and a third solar cell C3 on the third wire w3 ((g) in FIG. 2). Referring again to FIG. 1, the jig and the solar cell on the stage 100 placed at the stage retrieval unit 40' are picked up and separated from the stage 100 by the jig retrieval unit 71 and the cell conveying unit 50, respectively.

In the above order, the wires w and the jigs J are disposed on the solar cells C on the stages 100 and the curing process may proceed in the curing zone Z6 with the wires w bonded to the upper and lower surfaces of the solar cell C.

The stage 100 may convey the solar cell C and the wire w disposed on the solar cell C to the curing zone Z6. The stage 100 may enter the curing zone Z6 through rails L formed on opposite sides of the base 10 and may exit the curing zone Z6 through the rails L. Referring to FIG. 3, a plurality of stages 100 may be continuously fed to the curing zone Z6 in a connected state.

The plurality of stages 100 may be provided with a plurality of solar cells C each having the wires w thereon, respectively. As shown in FIG. 2, a wire disposed on an upper surface of one solar cell C may extend to be disposed on a lower surface of another solar cell C connected to one solar cell C. In addition, a wire disposed on a lower surface of the one solar cell C may extend to be disposed on an upper surface of another solar cell C connected to the one solar cell C. Here, both the upper surface and the lower surface of one solar cell C may have the wires disposed thereon.

The base 10 on which the stage 100 is conveyed is formed in an elongated shape such that the stage 100 can be moved into the curing zone Z6 on the base 10. The stage 100 is formed at a lower end thereof with a guide G, which remains in a connected state with the rails L formed on the base 10 and allows the stage 100 to move along the rails L.

Between the rails L formed on the opposite sides of the base 10, two shafts SH may be formed parallel to the rails L. When the stage 100 is conveyed along the rails L, the stage 100 may be conveyed, with the lower end of the stage 100 contacting the shafts SH.

Each of the rails L extends from one end of the base 10 to the other end thereof in a longitudinal direction thereof. On the other hand, the shafts SH extend to pass through the pre-heating zone Z5, the curing zone Z6, and the outlet zone Z7.

According to this embodiment, the manufacturing apparatus may further include a first heater H1 disposed between the two shafts SH on an upper surface of the base 10. In this embodiment, the first heater H1 is composed of three heaters and has a pipe structure extending in the longitudinal direction parallel to the shafts SH. However, it should be understood that the number and shape of the first heater H1 are not limited thereto.

The first heater H1 may have a length corresponding to the shafts SH. Thus, like the shafts SH, the first heater H1 extends through the pre-heating zone Z5, the curing zone Z6, and the outlet zone Z7. In this structure, a process of pre-heating the solar cell C may be performed in the pre-heating zone Z5, a process of curing the solar cell C may be performed in the curing zone Z6, and a process of relieving a temperature difference between the curing zone Z6 and the outside may be performed in the outlet zone Z7.

According to this embodiment, the first heater H1 may be a cartridge type heater.

The stage 100 having the solar cell C seated thereon may pass above the first heater H1. The first heater H1 may perform the curing process with respect to the solar cell C seated on the stage 100 while the stage 100 passes above the first heater H1.

The curing unit 20 is disposed above the base 10. The curing unit 20 is formed in a box shape open at a lower surface thereof. The curing unit 20 may be formed in an elongated shape in the longitudinal direction of the base 10 so as to cover a central portion of the base 10.

The curing unit 20 may be disposed to cover the curing zone Z6 of the base 10. However, in the event of failure or maintenance of the curing unit 20, the curing unit 20 may be opened to allow maintenance work to be performed on the interior of the curing unit 20.

A plurality of solar cells C disposed inside the curing unit 20 coupled to the central portion of the base 10 may be cured inside the curing unit 20, with each solar cell C seated on the corresponding stage 100. The curing unit 20 may be formed to accommodate as many stages 100 with the solar cells C seated thereon as possible in order to maximize the number of solar cells C to be cured.

Referring to FIG. 5, the curing unit 20 may be provided on an interior ceiling 21 thereof with a plurality of second heaters H2. According to this embodiment, the second heater H2 is composed of four heaters and has a pipe structure extending in a longitudinal direction parallel to the longitudinal direction of the curing unit 20. However, it should be understood that the number and shape of the second heater H2 are not limited thereto.

According to this embodiment, the second heater H2 may be an infrared (IR) heater.

Referring to FIG. 3 and FIG. 4, the base may further include the outlet zone Z7 to which the stage 100 having the solar cell C seated thereon is conveyed from the curing zone Z6. Here, the first heater H1 may be disposed in the curing zone Z6, the pre-heating zone Z5, and the outlet zone Z7. That is, the first heater H1 may extend beyond both ends of the second heater H2. After the curing process, the solar cell C conveyed out of the curing unit 20 may be subjected to post-heating by the first heater H1 in the outlet zone Z7. That is, the first heater H1 may be disposed in the outlet zone Z7 such that the solar cell C seated on the stage 100 does not undergo a sudden temperature change when the stage 100 is conveyed from a high temperature environment in the curing zone Z6 to the outside of the curing zone Z6. The first heater H1 disposed in the outlet zone Z7 can play a temperature buffering role to slowly reduce the temperature of the solar cell C disposed on the stage 100. As a result, quality of the cured solar cell can be further improved.

According to this embodiment, the plurality of stages 100 forms stage modules M1, M2 arranged in a row to contact each other, in which the stage modules M1, M2 are sequentially conveyed on the base 10. Here, pins P are inserted between two adjacent stage modules M1, M2. Here, a single solar cell module may be formed on one stage module.

Referring to FIG. 3, although only two stage modules M1, M2 are illustrated in this embodiment, it should be understood that a plurality of stage modules may be successively fed on the base 10 as the stages are fed.

A plurality of solar cells C on one stage module subjected to the curing process is connected to each other through a wire w. The plurality of solar cells C connected through the wire w may form a solar cell module.

According to this embodiment, regardless of the module, the wire W may be continuously fed onto a plurality of stages 100 continuously fed onto the base and may be divided through cutting operation for each solar cell module. Here, by adopting a process of feeding an integral wire, followed by cutting the wire without feeding a separate wire for each solar cell module, it is possible to reduce a tact time while improving manufacturing efficiency, as compared with a process of feeding a separate wire for each solar cell module.

In summary, in order to form each solar cell module from the plurality of stages 100 successively fed to the base, it is necessary to cut a portion of the wire connecting the solar cell modules to each other such that each solar cell module can be separated.

According to this embodiment, the solar cell manufacturing apparatus may include a pin feeder 200 configured to feed pins between two predetermined adjacent stages among the plurality of stages 100, in which the two stages 100 coupled to each other through the pins P fed from the pin feeder 200 may be spaced apart from each other.

Here, the wire w connecting the two stages spaced apart from each other can be easily cut by the cutting unit 51 using the gap G formed between the two stages.

According to this embodiment, pins P having a predetermined length are mounted between two stages 100, 100', whereby an operator can secure a desired gap G between the stages when cutting the wire. Thus, by simply replacing the pins P of the predetermined length in the pin feeder, the operator can efficiently secure the gap G between the two stages 100, 100' according to situations that can occur during the cutting operation, such as a location of the cutting unit, a cutting space, and the like.

Referring to FIG. 9, according to this embodiment, the cell conveying unit 50 may be provided with the cutting unit 51. That is, after the curing process is completed, the solar cells C separated from the stages and the jigs are conveyed to the cell conveying unit 50, which in turn may cut the wire between two adjacent solar cell modules through the cutting unit 51 in the cell conveying unit. By this operation, the solar cells can be divided into solar cell modules such that the solar cell modules can be individually conveyed on the base 10 to the outside.

For example, as shown in FIG. 8, the pins may have a length L2 ranging from about 10% to about 20% of a length L1 of the stage. For example, the length L2 of the pins may be 10%, 11%, 12%, 13%, 14%, 15%, 16%, 17%, 18%, 19%, or 20% of the length L1 of the stage. When the length L2 of the pins is less than 10% of the length of the stage L1, it is difficult to secure a sufficient space to facilitate the cutting operation. If the length L2 of the pins is greater than 20 percent of the length L1 of the stage, the number of solar cells C fed per unit area of the curing zone Z1 can be reduced, causing increase in manufacturing cycle time of the solar cell module.

In addition, since the plurality of stages 100 is conveyed with the pins P inserted between two stages 100, 100' during the conveying process, the process of conveying the plurality of stages 100 for the curing process can be performed while securing a gap for each stage module, whereby a subsequent process for each solar cell module can be more easily performed after the curing process.

Furthermore, since the gap G between the two stages 100, 100' into which the pins P are inserted is kept constant during the process of conveying the plurality of stages 100, as compared to a case where the conveying position or conveying speed of the stages is adjusted to form the gap between the stages, the wire cutting operation can be performed regardless of the conveying position of the plurality of stages.

In addition, since the widths of the plurality of stages and the gap G between the stage modules are calculated, it is possible to predict the manufacturing cycle time of the solar cell module. Furthermore, by adjusting the length of the pins P, the process can be carried out by setting an optimal gap G during the cutting operation, thereby reducing the manufacturing cycle time.

According to this embodiment, the pin feeder 200 may include a pin feeder body 200a and pin insertion units 210, 220 disposed at one side of the pin feeder body 200a and configured to insert at least one pin P into one side of the stage 100. The pin insertion units 210, 220 may include a first pin insertion unit 210 disposed at one side of the pin feeder body 200a and configured to insert a pin P into one side of the stage 100 and a second pin insertion unit 220 disposed at the other side of the pin feeder body 200a and configured to insert a pin P into the other side of the stage 100.

Here, the pins P are inserted between two adjacent stage modules 100, 100' and the first pin insertion unit 210 and the second pin insertion unit 220 may alternately insert the pins between the plurality of stage modules being conveyed on the base. In other words, when each of the stage modules constituted by the plurality of stages is fed onto the base 10, the first and second pin insertion units 210, 220 of the pin feeder 200 may alternately insert a first pin P1 and a second pin P2 between the plurality of stage modules being conveyed on the base.

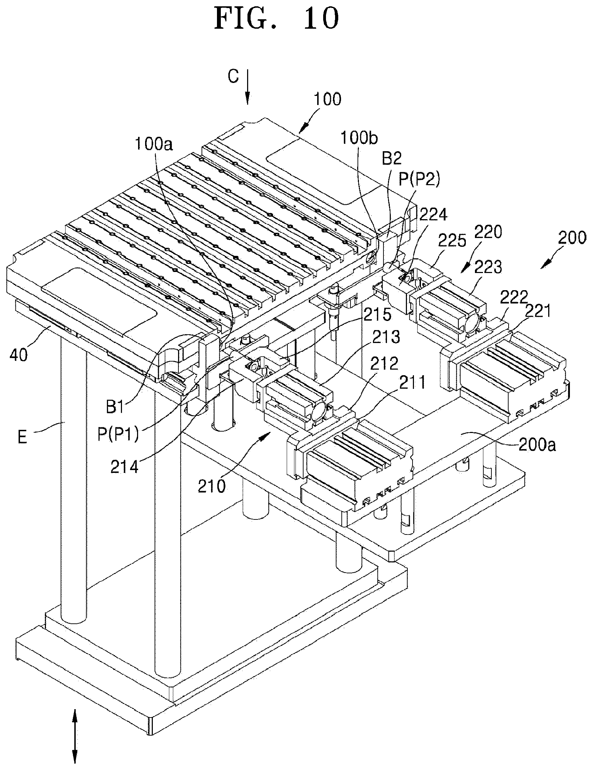

Next, referring to FIG. 10 to FIG. 15, the solar cell manufacturing apparatus according to the embodiment of the invention will be described in more detail. For components not shown in FIGS. 10 through 15, refer to the components shown in FIG. 1 to FIG. 9 and the description thereof.

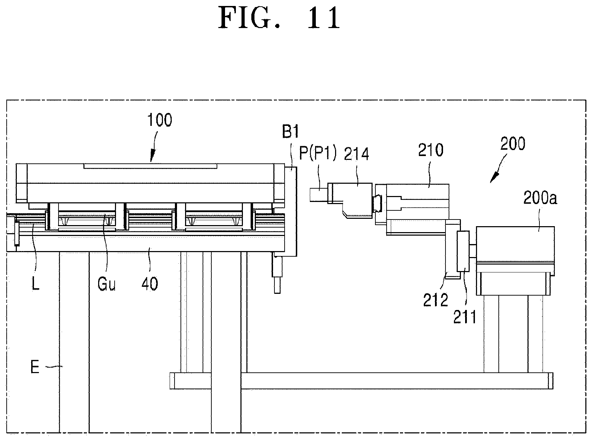

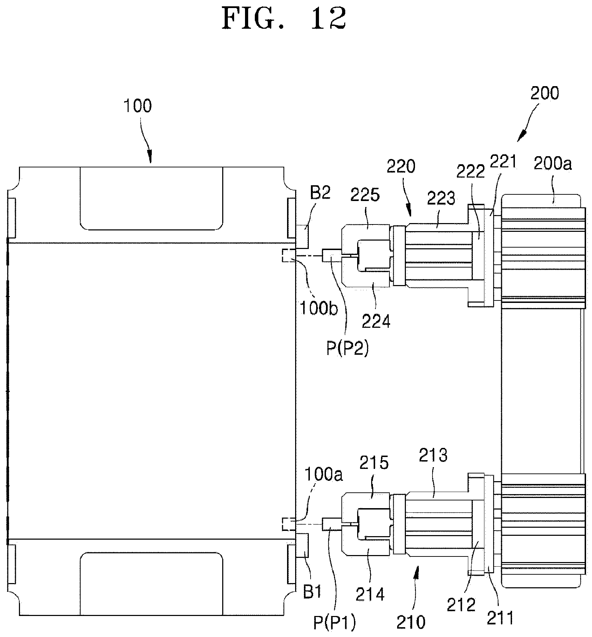

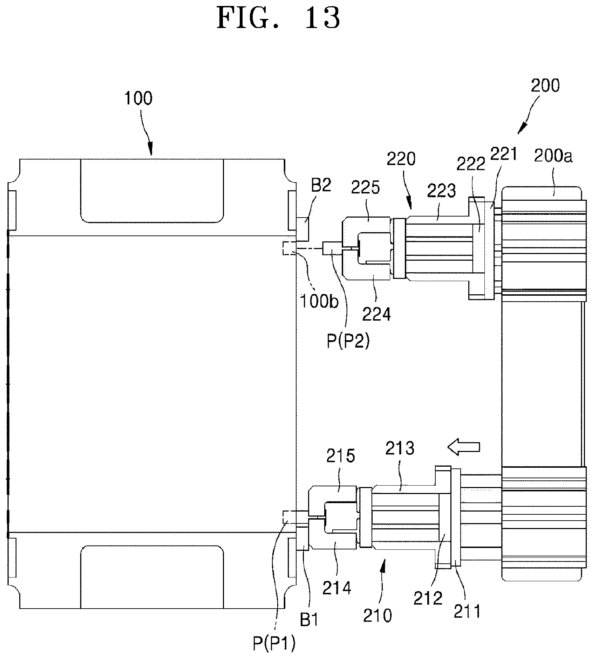

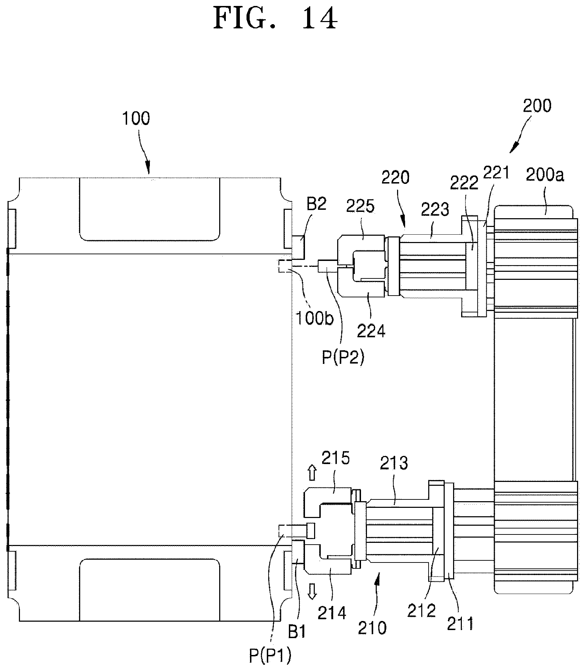

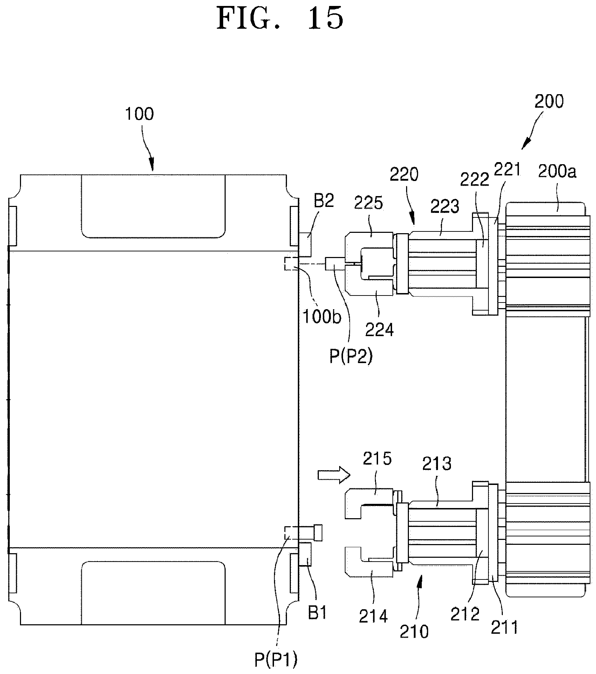

FIG. 10 is an enlarged perspective view illustrating a pin feeder according to one embodiment of the present invention, stages to which the pin feeder feeds the pins, and peripheral configurations. FIG. 11 is a side view of Part B of FIG. 4. FIG. 12 is a plan view of Part C of FIG. 10, illustrating a first pin gripper of a first pin insertion unit, which grips a first pin. FIG. 13 is a plan view of Part C of FIG. 10, illustrating a first pin insertion unit shifter of the first pin insertion unit, which shifts the first pin gripper in a direction in which the stage is disposed, and the first pin gripper inserting the first pin into a first pin insertion hole of the stage. FIG. 14 is a plan view of Part C of FIG. 10, illustrating the first pin gripper releasing a pin. FIG. 15 is a plan view of Part C FIG. 10, illustrating the first pin insertion unit shifter shifting the first pin gripper in a direction opposite to the stage.

Referring to FIG. 10 to FIG. 15, in the solar cell manufacturing apparatus according to the embodiment of the present invention, the stage is formed on a side surface thereof with first and second pin insertion holes 100a, 100b, and first and second pins P1, P2 may be inserted into the first and second pin insertion holes 100a, 100b, respectively.

For example, the first pin insertion unit 210 may feed the first pin P1 to the first pin insertion hole 100a of the stage 100 disposed between a firstly supplied stage module and a secondly supplied stage module. In addition, the second pin insertion unit 220 may feed the second pin P2 to the second pin insertion hole 100b of the stage 100 disposed between the firstly supplied stage module and the secondly supplied stage module.

When the first pin insertion unit 210 feeds a pin to a certain stage 100, the second pin insertion unit 220 may receive a new pin and prepare to feed the received new pin to the next stage 100. In addition, when the second pin insertion unit 220 feeds a pin to the next stage 100, the first pin insertion unit 210 may receive a new pin and prepare to feed the received new pin to a third stage 100.

According to this embodiment, the first pin insertion unit 210 includes a first pin insertion unit body 213, a first pin insertion unit shifter 211 that shifts the first pin insertion unit body 213 relative to the pin feeder body 200a while advancing toward the stage 100, and a first pin insertion unit connector 212 that connects the first pin insertion unit body 213 to the first pin insertion unit shifter 211, and first pin grippers 214, 215 mounted on the first pin insertion unit body 213 to grip the first pin P1.

The second pin insertion unit 220 also includes a second pin insertion unit body 223, a second pin insertion unit shifter 221 that shifts the second pin insertion unit body 223 relative to the pin feeder body 200a while advancing towards the stage 100, a second pin insertion unit connector 222 that connects the second pin insertion unit body 223 to the second pin insertion unit shifter 221, and second pin grippers 224, 225 mounted on the second pin insertion unit body 223 to grip the second pin P2.

According to this embodiment, the first pin grippers 214, 215 may detachably attach the first pin P1 to the stage 100 and the second pin grippers 224, 225 may detachably attach the second pin P2 to the stage 100. That is, the first pin grippers 214, 215 may attach the first pin P1 to the stage 100 or may remove the first pin P1 from the first pin insertion hole 100a of the stage 100. Similarly, the second pin grippers 224, 225 may attach the second pin P2 to the stage or may remove the second pin P2 from the second pin insertion hole 100b of the supplied stage 100. This is because a plurality of successively fed stages 100 may be categorized into stages to be fed pins P and stages not to be fed the pins P, as will be described below.

Here, the pins P1, P2 gripped by the first and second pin grippers 214, 215; 224, 225 may be replaced by pins having different lengths depending on circumstances.

The pin feeder 200 may be provided at one side thereof with the stage feeder 40 in which the stages 100 configured to receive the pins P may be seated. The pin feeder 200 may be disposed at one side of the stage 100 seated on the stage feeder 40 and the base 10 may be disposed at the other side facing the one side of the stage 100.

The stage feeder 40 is coupled to an elevator E. The stage feeder 40 and the stage 100 seated on the stage feeder 40 may be lifted through the elevator E. The pin feeder 200 may be disposed at one side of the stage feeder 40 and the stage 100 lifted upward, and the base 10 may be disposed at the other side facing the one side thereof.

Accordingly, the pin P is inserted into the pin insertion hole formed on one side surface of the stage 100 through the pin feeder 200 disposed at one side of the stage 100, and the stage 100 having the pin P inserted thereinto may be conveyed to the base 10 disposed at the other side of the stage 100.

The pin feeder 200 may not feed the pin P to the stage 100. That is, the stage feeder 40 and the stage 100 lifted through the elevator E may be directly conveyed to the base 10 without being fed a pin through the pin feeder 200.

For example, when the stage 100 being conveyed to the base 10 is a stage 100' disposed at an end opposite to a conveying direction X of a plurality of stages disposed in a row and constituting the stage module M1, the pin P may be fed to the corresponding stage.

In addition, when the stage 100 being conveyed to the base 10 is a remaining stage excluding the stage 100' disposed at the end opposite to the conveying direction X among the plurality of stages, the pin P may not be fed to the corresponding stage.

A controller may determine whether the lifted stage 100 is a stage that needs to be fed the pin P in sequence or a stage that does not need to be fed the pin P, and may send a signal to the pin feeder 200 as to whether the pin P is to be fed to the corresponding stage.

According to this embodiment, the stage feeder 40 may include gripper contact portions B1, B2 that contact the pin feeder 200 when the pin P is inserted into the stage 100.

Specifically, the stage feeder 40 may include a first gripper contact portion B1 that contacts the first pin grippers 214, 215 when the first pin P1 is inserted into the stage, and a second gripper contact portion B2 that contacts the second pin grippers 224, 225 when the second pin P2 is inserted into the stage.

The first and second gripper contact portions B1, B2 may act as stoppers that set a distance by which the first and second pin grippers 214, 215; 224, 225 are advanced for pin insertion. Accordingly, when the first and second pin grippers 214, 215; 224, 225 are shifted toward the stage 100 by the first and second pin insertion unit shifters 211, 221, the first and second pin grippers 214, 215; 224, 225 are brought into contact with the first and second gripper contact portions B1, B2, respectively, and the first and second pin insertion unit shifters 211, 221 stop movement of the first and second pin grippers 214, 215, 224, 225. As a result, the first and second pins P1, P2 fed by the first and second pin grippers 214, 215, 224, 225 can be inserted into the first and second pin insertion holes 100a, 100b of the stages 100 under an appropriate pressure, respectively.

Next, with reference to FIG. 11 to FIG. 18, a solar cell manufacturing method according to one embodiment of the present invention will be described. For description of details not shown in FIG. 11 to FIG. 18, refer to the description with reference to FIG. 1 to FIG. 9.

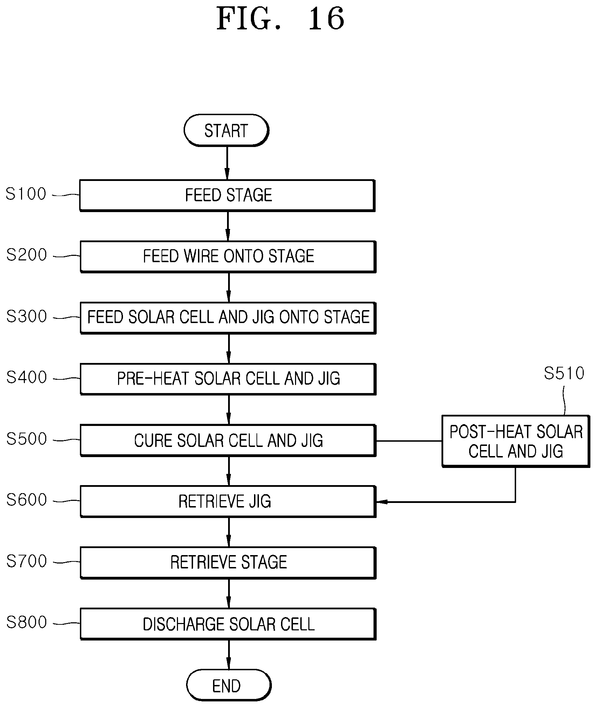

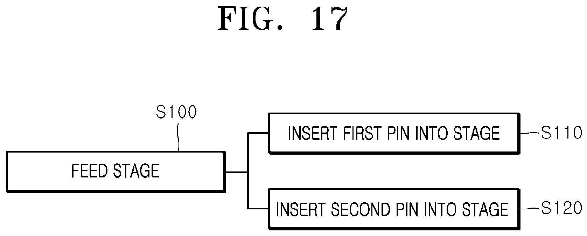

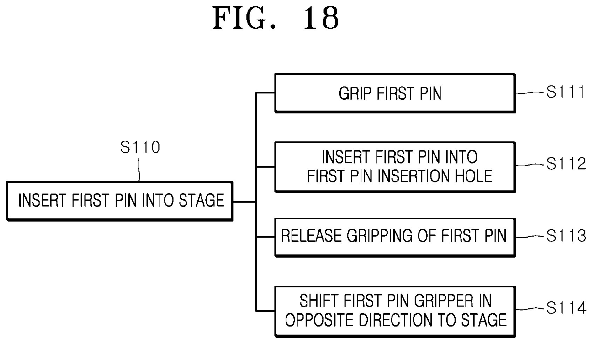

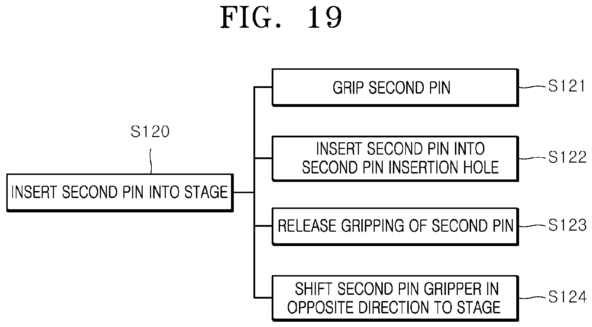

FIG. 11 is a side view of Part B of FIG. 4. FIG. 12 is a plan view of Part C of FIG. 10, illustrating a first pin gripper of a first pin insertion unit gripping a first pin. FIG. 13 is a plan view of Part C of FIG. 10, illustrating a first pin insertion unit shifter of the first pin insertion unit moving the first pin gripper in a direction in which the stage is disposed, and the first pin gripper inserting the first pin into a first pin insertion hole of the stage. FIG. 14 is a plan view of Part C of FIG. 10, illustrating the first pin gripper releasing a pin. FIG. 15 is a plan view of Part C FIG. 10, illustrating the first pin insertion unit shifter shifting the first pin gripper in a direction opposite to the stage. FIG. 16 is a flowchart illustrating a method of manufacturing a solar cell according to one embodiment of the present invention. FIG. 17 is a flowchart illustrating detailed steps in operation of a pin feeder according to one embodiment of the present invention. FIG. 18 is a flowchart illustrating detailed steps in which a first pin insertion unit disposed at one side of a pin feeder body of FIG. 17 inserts a first pin into a first pin insertion hole of one stage. FIG. 19 is a flowchart illustrating detailed steps in which a second pin insertion unit disposed at one side of the pin feeder body of FIG. 17 inserts a second pin into a second pin insertion hole of one stage.

Referring to FIG. 16, a solar cell manufacturing method according to one embodiment of the present invention may be performed while the stage 100 is moved by a preset pitch P at a time. For example, as the fed stage 100 is moved by a preset pitch P at a time, a wire w, a solar cell C, and a jig J may be disposed on the stage 100 to perform processes, such as heating, curing, and discharge.

The solar cell manufacturing method according to this embodiment includes the steps of: feeding a stage (S100); feeding a wire onto the stage (S200); feeding a solar cell and a jig onto the stage (S300); pre-heating the solar cell and the jig (S400); curing the solar cell and the jig (S500); and discharging the solar cell (S800).

The step of feeding a stage (S100) may refer to the step of feeding the stage. For example, Step S100 may refer to a step in which the stage feeder 40 is raised and feeds a stage 100 to the stage feeding zone Z2. The stage 100 fed in the stage feeding step S100 may be conveyed by one pitch P at a time according to a process sequence.

The step of feeding a wire onto the stage (S200) may be performed after feeding the stage (S100). The step of feeding a wire onto the stage (S200) may refer to a step in which the wire feeder 30 feeds a wire w onto the stage 100. For example, Step S200 may refer to the step of feeding the wire onto the stages 100 placed in the solar cell seating zone Z3 and the jig securing zone Z4. Specifically, in Step S200, the wire feeder 30 may extend the wire w to the stage feeding zone Z2, the solar cell seating zone Z3, and the jig securing zone Z4 through the grippers. Here, the extending wire w may be guided by a wire groove formed on the stage 100.

The step of feeding a solar cell and a jig onto the stage (S300) may be performed after the step of feeding the wire onto the stage (S200). The step of feeding the solar cell and the jig onto the stage S300 may refer to the step of feeding the solar cell C and the jig J onto the stage 100 on which the wire w is disposed. For example, Step S300 may refer to the step of feeding the solar cell C onto the stage 100 disposed in the solar cell seating zone Z3 and the jig J onto the stage 100 disposed in the jig securing zone Z4. In Step S300, the solar cell C and the jig J may be simultaneously fed to the respective zones by the cell-jig conveying unit 91. Further, the wire w disposed on the solar cell C by the jig J fed in Step S300 may be secured thereto. That is, the wire w1, the solar cell C, the wire w2, and the jig may be sequentially disposed on the stage 100 in the jig securing zone Z4, as shown in (e) of FIG. 2.

The step of pre-heating the solar cell and the jig (S400) may be performed after the step of feeding the solar cell and the jig onto the stage (S300). The step of pre-heating the solar cell and the jig (S400) may refer to a step in which the solar cell C and the wire w disposed on the stage 100 are pre-heated by the first heater H1 in the pre-heating zone Z5. For example, as shown in (f) of FIG. 2, in Step S400, the solar cell C, and the lower and upper wires w1, w2 disposed respectively on the upper and lower surfaces of the solar cell C may be pre-heated by the first heater H1 in the pre-heating zone Z5. Here, the first heater H1 may be disposed on the upper surface of the base 10, which conveys and supports the stage 100 described above.

The step of curing the solar cell and the jig (S500) may be performed after the step of pre-heating the solar cell and the jig (S400). The step of curing the solar cell and the jig (S500) may refer to a step in which the solar cell C and the wires w disposed on the stage 100 are cured by the first and second heaters H1, H2 in the curing zone Z6. For example, in Step S500, the solar cell C and the lower and upper wires w1, w2 disposed respectively on the upper and lower surfaces of the solar cell C may be cured by the first and second heaters H1, H2 in the curing zone Z6. Here, the second heater H2 may be disposed inside the curing unit 20 disposed above the base 10 described above. The stage 100 may be conveyed between the first and second heaters H1, H2. Through Step S500, an electrically conductive adhesive (ECA) deposited on the upper and lower surfaces of the solar cell C may be cured, thereby allowing the wires w1 , w2 disposed on the upper and lower surfaces of the solar cell C to be physically and electrically connected to the solar cell C.

The step of discharging the solar cell (S800) may be performed after the step of cuing the solar cell and the jig (S500). In Step S800, the solar cell C having the wires w1, w2 connected to the upper and lower surfaces thereof may be discharged. For example, the solar cell C with the wires w1, w2 connected thereto may be separated and discharged from the stage 100 through the cell conveying unit 50.

The solar cell manufacturing method according to the embodiment of the present invention may further include the step of post-heating the solar cell and the jig (S510). The step of post-heating the solar cell and the jig (S510) may be performed between the step of curing the solar cell and the jig (S500) and the step of discharging the solar cell (S800). For example, Step S510 may refer to the step of post-heating the solar cell C, which has left the curing unit 20 after the curing step S500, with the first heater H1 in the outlet zone Z7. Step S510 may acts as a buffering step by slowly reducing the temperature of the solar cell C having left the curing unit 20 in the outlet zone Z7. Step S510 can prevent the cured solar cell C from undergoing a sudden temperature change, thereby further improving quality of the solar cell C.

The solar cell manufacturing method according to the embodiment of the present invention may further include the step of retrieving the jig (S600). The step of retrieving the jig (S600) may be performed between the step of curing the solar cell and the jig (S500) and the step of discharging the solar cell (S800). For example, Step S600 may refer to the step of retrieving the jig J placed on the stage 100 after the stage 100 passes through the curing zone Z6 and the outlet zone Z7. Specifically, in Step S600, the jig J disposed on the stage retrieval unit 40' may be separated and retrieved from the stage 100 and the solar cell C through the jig retrieval unit 71. Alternatively, Step S600 may refer to the step of retrieving the jig J disposed in a jig retrieval region (not shown) placed between the outlet zone Z7 and the stage retrieval unit 40'. Here, the jig retrieval unit 71 described above may be disposed in a region corresponding to the jig retrieval region.

The solar cell manufacturing method according to the embodiment of the present invention may further include the step of retrieving the stage (S700). The step of retrieving the stage (S700) may be performed between the step of curing the solar cell and the jig (S500) and the step of discharging the solar cell (S800). For example, Step S700 may refer to the step of retrieving the stage 100 disposed on the stage 100 that has passed through the curing zone Z6 and the outlet zone Z7. Specifically, in Step S700, the stage 100 may be retrieved through the stage retrieval unit 40'. The stage retrieval unit 40' is connected to the stage feeder 40, and the stage 100 retrieved through the stage retrieval unit 40' may be conveyed to the stage feeder 40. The stage feeder 40 may refeed the conveyed stage 100 to the stage feeding zone Z2.

As such, as the stage 100 is sequentially moved through the stage feeding zone Z2, the solar cell seating zone Z3, the jig securing zone Z4, the pre-heating zone Z5, the curing zone Z6, and the outlet zone Z7, the preparation and execution of the curing process with respect to the solar cell C may be performed in sequence.

That is, the processes, in which the wire w is fed to the stage 100, the solar cell C is disposed thereon, the wire w is disposed on both surfaces of the solar cell C, and the jig J presses the wire w disposed on the upper surface of the solar cell C, are sequentially carried out. Then, after the step of pre-heating the solar cell C through the first heater H1, the stage 100, on which the solar cell C with the wire w disposed thereon is seated, enters the curing zone Z6 defined by the curing unit 20 and is subjected to the curing process therein, whereby the curing process can be systematically and stably performed.

In addition, after the curing process is complete, the stages and the jigs used to convey the solar cells may be retrieved and refed, thereby enabling recycling of components.

Next, operation of the pin feeder will be described in more detail.

Referring to FIG. 17, in the solar cell manufacturing method according to the embodiment, the step S100 of feeding a stage may include the steps of: inserting a first pin into one stage (S110) and inserting a second pin into another stage (S120).

For example, the step of inserting a first pin into one stage (S110) may refer to a step in which the first pin insertion unit 210 disposed at one side of the pin feeder body 200a inserts a first pin P1 into a first pin insertion hole 100a of one stage. In addition, the step of inserting a second pin into another stage (S120) may refer to a step in which the second pin insertion unit 220 disposed on the other side of the pin feeder body 200a inserts a second pin P2 into a second pin insertion hole 100b of another stage. The step of inserting a first pin into one stage (S110) and the step of inserting a second pin into another stage (S120) may be alternately repeated.

Referring to FIG. 12 to FIG. 15 and FIG. 18, the step of inserting a first pin into one stage (S110) includes the steps of: gripping the first pin P1 (S111); inserting the first pin P1 into the first pin insertion hole 100a (S112); releasing gripping of the first pin P1 (S113); and shifting the pin feeder 200 in a direction different from a location at which the stage 100 is disposed (S114). Specifically, the step of shifting the pin feeder 200 in a direction different from a location at which the stage 100 is disposed (S114) may include shifting the first pin grippers 214, 215 in the direction different from the location at which the stage is disposed, that is, in a direction opposite to a direction in which the stage is disposed.

For example, the step of gripping the first pin P1 (S111) may refer to a step in which the first pin grippers 214, 215 grip the first pin P1. Further, the step of inserting the first pin P1 into the first pin insertion hole 100a (S112) may refer to a step in which the first pin insertion unit shifter 211 of the first pin insertion unit 210 shifts the first pin grippers 214, 215 in a direction in which one stage is disposed, and the first pin grippers 214, 215 insert the first pin P1 into the first pin insertion hole 100a of the one stage. Further, the step of releasing gripping of the first pin P1 (S113) may refer to a step in which gripping of the first pin P1 by the first pin grippers 214, 215 is released. Further, the step of shifting the first pin grippers 214, 215 in a direction opposite to the stage (S114) may refer to a step in which the first pin insertion unit shifter 211 shifts the first pin grippers 214, 215 in the direction opposite to the stage 100. The aforementioned steps may be sequentially performed by the controller.

Referring to FIG. 12, the first pin grippers 214, 215 of the first pin insertion unit 210 may grip the first pin P1. Here, both the first pin gripper 214, 215 may be kept in contact with each other to grip the first pin P1 inserted between the two grippers.

The first pin P1 gripped by the grippers may be replaced with a pin having a different shape or a different length corresponding to a cutting situation.

Referring to FIG. 13, the first pin insertion unit shifter 211 of the first pin insertion unit 210 shifts the first pin grippers 214, 215 in the direction in which one stage is disposed, and the first pin grippers 214, 215 may insert the first pin P1 into the first pin insertion hole 100a of the one stage.

Here, the first pin grippers 214, 215 may insert the first pin P1 into the first pin insertion hole 100a in a state of gripping the first pin P1. The first pin grippers 214, 215 may insert the first pin P1 into the first pin insertion hole 100a while advancing toward the stage 100.

Here, when the first pin grippers 214, 215 come into contact with the first gripper contact portion B1 coupled to the stage feeder 40, the first pin grippers 214, 215 stop gripping behavior and the first pin P1 can remain inserted to a preset depth in the first pin insertion hole 100a.

Referring to FIG. 14, gripping of the first pin P1 by the first pin grippers 214, 215 may be released. Here, both the first pin grippers 214, 215 may release gripping and spread apart to disengage from the first pin P1. The first pin P1 may be separated from the first pin grippers 214, 215 while remaining inserted into the first pin insertion hole 100a. Gripping and releasing operation by both the first pin grippers 214, 215 may be driven by a motor of the first insertion unit body. The first insertion unit body may receive a signal as to gripping operation from the controller and may selectively drive gripping and releasing operation of both grippers in response to the signal.

Referring to FIG. 15, the first pin insertion unit shifter 211 may shift the first pin grippers 214, 215 in a direction opposite to the stage 100. As a result, the first pin grippers 214, 215 may return to an original position thereof without gripping the first pin P1. Then, a new pin is gripped by the first pin gripper 214, 215 and a new stage is fed again through the stage feeder 40. When the new stage is a stage that requires a pin to be seated, the stage feeder 40 may be advanced again towards the corresponding stage to mount the new pin onto the stage.

Although the operation of the first pin insertion unit 210 is described above, it should be understood that the operation of the second pin insertion unit 220 may also be performed in a method corresponding to the operation method of the first pin insertion unit 210.

That is, referring to FIG. 12 to FIG. FIG. 15 and FIG. 19, the step of inserting a second pin into the stage (S120) includes the steps of: gripping the second pin P2 (S121); inserting the second pin P2 into the second pin insertion hole 100b (S122); releasing gripping of the second pin P2 (S123); and shifting the pin feeder 200 in a direction different from a location at which the stage 100 is disposed (S124). Specifically, the step of shifting the pin feeder 200 in a direction different from a location at which the stage 100 is disposed (S124) may include the step of shifting the second pin grippers 224, 225 in a direction different from the location at which the stage is disposed, that is, in a direction opposite to a direction in which the stage is disposed.

For example, the step of gripping the second pin P2 (S121) may refer to a step in which the second pin grippers 224, 225 grip the second pin P2. Further, the step of inserting the second pin P2 into the second pin insertion hole 100b (S122) may refer to a step in which the second pin insertion unit shifter 221 of the second pin insertion unit 220 shifts the second pin grippers 224, 225 in a direction in which one stage is disposed, and the second pin grippers 224, 225 insert the second pin P2 into the second pin insertion hole 100b of the one stage. Further, the step of releasing gripping of the second pin P2 (S123) may refer to a step in which gripping of the second pin P2 by the second pin grippers 224, 225 is released. Further, the step of moving the second pin grippers 224, 225 in a direction opposite to the stage (S124) may refer to a step in which the second pin insertion unit shifter 221 shifts the second pin grippers 224, 225 in the direction opposite to the stage 100. The aforementioned steps may be sequentially performed by the controller.

Referring to FIG. 12, the second pin grippers 224, 225 of the second pin insertion unit 220 may grip the second pin P2. Here, both the second pin grippers 224, 225 may be kept in contact with each other to grip the second pin P2 inserted between the two grippers.

The second pin P2 gripped by the grippers may be replaced with a pin having a different shape or a different length corresponding to a cutting situation.

Referring to FIG. 13, the second pin insertion unit shifter 221 of the second pin insertion unit 220 shifts the second pin grippers 224, 225 in the direction in which one stage is disposed, and the second pin grippers 224, 225 may insert the second pin P2 into the second pin insertion hole 100b of the one stage.

Here, the second pin gripper 224, 225 may insert the second pin P2 into the second pin insertion hole 100b in a state of gripping the second pin. The second pin gripper 224, 225 may insert the second pin P2 into the second pin insertion hole 100b while advancing toward the stage 100.

When the second pin grippers 224, 225 come into contact with the second gripper contact portion B2 coupled to the stage feeder 40, the second pin grippers 224, 225 stop gripping behavior and the second pin P2 can remain inserted to a preset depth in the second pin insertion hole 100b.

Referring to FIG. 14, gripping of the second pin P2 by the second pin grippers 224, 225 may be released. Here, both grippers of second pin grippers 224, 225 may release gripping and spread apart to disengage from the second pin P2. The second pin P2 may be separated from second pin grippers 224, 225 while remaining inserted into the second pin insertion hole 100a. Gripping and releasing operation by both grippers of second pin grippers 224, 225 may be driven by a motor of the second insertion unit body. The second insertion unit body may receive a signal as to gripping operation from the controller and may selectively drive gripping and releasing operation of both grippers in response to the signal.

Referring to FIG. 15, the second pin insertion unit shifter 221 may shift the second pin grippers 224, 225 in a direction opposite to the stage 100. As a result, the second pin grippers 224, 225 may return to an original position thereof without gripping the second pin P2. Then, a new pin is gripped by the second pin grippers 224, 225 and a new stage is fed again through the stage feeder 40. When the new stage is a stage that requires a pin to be seated, the stage feeder 40 may be advanced again towards the corresponding stage to mount the new pin onto the stage.

Although the present invention has been described with reference to the embodiments and the drawings, it should be understood that these embodiments are provided by way of illustration only and that various modifications, changes, and alterations can be made without departing from the spirit and scope of the invention. The scope of the invention should be defined by the appended claims.

Specific technical details described in the embodiments are provided by way of example and do not limit the scope of the invention. In order to make the description of the invention concise and clear, descriptions of typical techniques and configurations in the art may be omitted. In addition, connections of lines or connection members between components shown in the drawings are given for illustration of functional connections and/or physical or circuit connections, which may be represented by various alternative or additional functional connections, physical connections, or circuit connections in an actual device. Furthermore, components may not be required for application of the present invention unless specifically stated as "essential," "important," or the like.

The word "the" or similar directives in the description and claims of the invention may refer to both singular and plural, unless otherwise specified. Furthermore, when a range is recited in an embodiment, it is intended to include the invention with individual values within the range (unless indicated otherwise) and means that each individual value constituting the range is recited in the description of the invention. In addition, the steps constituting a method according to an embodiment may be performed in any suitable order, unless an explicit order is stated or unless indicated otherwise. It should be understood that embodiments are not necessarily limited by the order in which the steps are described. The use of any examples or exemplary terms (for example, "and the like") in the embodiments is intended merely to describe the embodiments in detail and is not intended to limit the scope of the embodiments, unless limited by the claims. Furthermore, a person having ordinary knowledge in the art will recognize that various modifications, combinations, alterations, and changes can be made in accordance with design conditions and factors within the scope of the appended claims or equivalents thereto.

## Claims

1. A solar cell manufacturing apparatus comprising:
a plurality of stages arranged in a row to contact each other and each having a solar cell seated thereon;
a base conveying the plurality of stages to a curing zone while supporting the plurality of stages; and
a pin feeder disposed at one side of the base and feeding a pin between two predetermined adjacent stages among the plurality of stages,
wherein the two stages coupled to the pin fed through the pin feeder are spaced apart from each other.

2. The solar cell manufacturing apparatus according to claim 1, wherein
the pin feeder comprises:
a pin feeder body; and
a pin insertion unit disposed in the pin feeder body and inserting at least one pin into one side of the stage.

3. The solar cell manufacturing apparatus according to claim 2, wherein
the plurality of stages forms a plurality of stage modules arranged in a row while contacting each other,
the plurality of stage modules is sequentially conveyed on the base, and
the pin is inserted between two adjacent stage modules.

4. The solar cell manufacturing apparatus according to claim 3, wherein
the pin insertion unit comprises:
a first pin insertion unit disposed at one side of the pin feeder body and inserting a first pin into one side of the stage; and
a second pin insertion unit disposed at the other side of the pin feeder body and inserting a second pin into the other side of the stage,
the first and second pin insertion units alternately inserting the first pin and the second pin between the plurality of the stage modules being conveyed.

5. The solar cell manufacturing apparatus according to claim 2, further comprising:
a stage feeder receiving a stage into which the pin is to be inserted, the stage feeder placing the stage at a location thereon corresponding to the pin feeder.

6. The solar cell manufacturing apparatus according to claim 5, wherein
the stage feeder comprises a gripper contact portion contacting the pin feeder when the pin is inserted into the stage.

7. The solar cell manufacturing apparatus according to claim 1, wherein
the pin has a length (L2) ranging from about 10% to about 20% of a length (L1) of the stage.

8. The solar cell manufacturing apparatus according to claim 1, wherein
each of the stages is formed on a side surface thereof with a pin insertion hole, and
the pin is inserted into the pin insertion hole.

9. A solar cell manufacturing method comprising:
feeding a stage;
feeding a wire onto the stage;
feeding a solar cell and a jig onto the stage fed the wire;
pre-heating the solar cell and the jig on the stage;
curing the solar cell and the jig on the stage; and
discharging the solar cell,
wherein the step of feeding a stage comprise:
inserting a first pin into the stage; and
inserting a second pin into the stage.

10. The solar cell manufacturing method according to claim 9, wherein
the step of inserting a first pin into the stage and the step of inserting a second pin into the stage are alternately performed.

11. The solar cell manufacturing method according to claim 9, wherein
the step of inserting a first pin into the stage comprises:
gripping the first pin;
inserting the first pin into a first pin insertion hole of the stage;
releasing gripping of the first pin; and
shifting a pin feeder in a direction different from a location at which the stage is disposed.
